Europäisches Patentamt

European Patent Office

Office européen des brevets

(19)

(11) EP 0 573 325 B1

## (12) FASCICULE DE BREVET EUROPEEN

(45) Date de publication et mention
de la délivrance du brevet:
**29.12.1997 Bulletin 1997/52**

(51) Int Cl.6: **C03C 17/22**, C03C 17/245,
C03C 17/34, C23C 16/30

(21) Numéro de dépôt: **93401297.2**

(22) Date de dépôt: **19.05.1993**

(54) **Vitrage muni d'une couche fonctionnelle**

Glasscheibe mit einer Funktionsschicht

Window provided with a functional coating

(84) Etats contractants désignés:
**AT BE CH DE DK ES FR GB IE IT LI LU NL PT SE**

(30) Priorité: **11.02.1993 FR 9301545**
**26.05.1992 FR 9206449**

(43) Date de publication de la demande:
**08.12.1993 Bulletin 1993/49**

(73) Titulaire: **SAINT-GOBAIN VITRAGE**
**92400 Courbevoie (FR)**

(72) Inventeurs:
• **Balian, Pierre**
**F-75015 Paris (FR)**

• **Oudard, Jean-François**
**F-60310 Thiescourt (FR)**

(74) Mandataire: **Muller, René et al**
**SAINT-GOBAIN RECHERCHE,**
**39, quai Lucien Lefranc-BP 135**
**93303 Aubervilliers Cédex (FR)**

(56) Documents cités:
EP-A- 0 335 769          EP-A- 0 413 617
EP-A- 0 441 705          EP-A- 0 454 349
EP-A- 0 465 309          EP-A- 0 489 621
EP-A- 0 511 044          EP-A- 0 518 755
FR-A- 2 439 167          US-A- 4 895 734

## Description

L'invention a trait à un vitrage comprenant un substrat en verre muni d'une couche mince fonctionnelle, cette dernière présentant des propriétés de transparence, de conductivité électrique et/ou de basse émissivité.

Elle concerne également les procédés d'obtention d'un tel vitrage, en particulier à l'aide de techniques de pyrolyse ou de techniques utilisant le vide.

Ce type de couche fonctionnelle trouve tout particulièrement application pour les vitrages destinés au bâtiment : revêtu d'une couche basse-émissive, un substrat de verre permet de réduire l'émission dans l'infra-rouge lointain à travers le vitrage dont il fait partie, de l'intérieur vers l'extérieur du local. En réduisant les pertes énergétiques dûes en partie à cette fuite de rayonnement, on améliore sensiblement le confort des habitants, notamment en hiver. Le substrat ainsi revêtu puis associé à un autre substrat par l'intermédiaire d'une lame de gaz, la couche basse-émissive se trouvant en face 3, (en comptant à partir de la face la plus extérieure) constitue un double-vitrage isolant très efficace.

Ces couches trouvent également application pour les vitrages destinés à l'automobile, de par leurs propriétés de conduction électrique, par exemple pour former des vitrages chauffants en prévoyant des arrivées de courant.

Les couches d'oxydes métalliques présentant ces propriétés sont par exemple des couches d'oxyde d'indium dopé à l'étain (ITO), ou d'oxyde de zinc dopé à l'aluminium (ZnO:Al), à l'indium (ZnO:In), à l'étain (ZnO:Sn), ou au fluor (ZnO:F), ou d'oxyde d'étain dopé au fluor ($SnO_2$:F).

Ces couches d'oxyde métallique peuvent être obtenues par différents procédés : par des procédés sous vide (évaporation thermique, pulvérisation cathodique, éventuellement à l'aide de magnétron) ou par pyrolyse de composés organo-métalliques projetés par un gaz vecteur sous forme liquide, solide ou gazeuse sur la surface du substrat en verre chauffé à une température élevée mais néanmoins inférieure à sa température de ramollissement. Ceux-ci, mis ainsi en contact avec une surface chaude, se décomposent en s'oxydant pour former sur celle-ci une couche d'oxyde métallique. Cette dernière technique est tout particulièrement avantageuse dans la mesure où elle permet d'envisager des dépôts directement sur le ruban de verre d'une ligne de fabrication type float de manière continue.

Cependant, pour que ces couches atteignent un niveau de performance élevé, notamment en termes de valeurs d'émissivité et/ou de conduction électrique, leur épaisseur doit être d'au moins 180 nm voire au-delà de 400 nm, et usuellement comprise entre 300 et 400 nm. Une couche mince présentant de telles épaisseurs confère au substrat qu'elle revêt un aspect en réflexion, notamment une coloration "côté couche", qui peut ne pas être très appréciée d'un point de vue esthétique.

Se pose ainsi le problème de l'aspect en réflexion, tout particulièrement de la coloration résiduelle obtenue "côté couche", du substrat ainsi revêtu. En effet, selon l'enseignement du brevet EP-B-0 125 153, une couche d'oxyde d'étain dopé au fluor $SnO_2$:F dont l'épaisseur, faible, est d'environ 163 à 165 nm, déposée sur un substrat de verre float clair de 4 mm d'épaisseur confère à ce dernier une coloration en réflexion dans les bleus, coloration très appréciée actuellement aussi bien dans le domaine du bâtiment que de l'automobile. Par contre, il a été constaté qu'une couche de même nature mais cette fois d'une épaisseur de 360 nm, donc une couche présentant de meilleurs performances, confère à un même substrat un aspect en réflexion côté couche dans les pourpres, couleur qui est peu recherchée pour des raisons esthétiques.

Le but de l'invention est alors de pallier cet inconvénient en mettant au point un substrat qui puisse à la fois être muni d'une couche fonctionnelle présentant de bonnes performances et présenter un aspect coloré en réflexion le plus agréable à l'oeil possible et tout particulièrement dans la gamme des bleus.

Le vitrage selon l'invention est defini dans le revendication 1 et comprend un substrat en verre muni d'au moins une couche mince transparente fonctionnelle, conductrice et/ou basse émissive, ainsi que d'une autre couche mince dite intermédiaire disposée entre substrat et couche fonctionnelle. L'épaisseur optique de cette couche intermédiaire est choisie comprise entre 168 ou 185 nm, ceci de manière à obtenir une couleur résiduelle en réflexion "côté couches" du substrat qui appartienne à la gamme des bleus. La gamme des bleus est définie, dans le cadre de l'invention, par une gamme de longueurs d'onde comprise entre 462 et 490 nanomètres approximativement.

La couche fonctionnelle peut avantageusement avoir une épaisseur entre 300 et 420 nm. Son indice de réfraction est généralement d'environ 1,9.

Concernant la couche intermédiaire, celle-ci, de préférence, est choisie de manière à avoir un indice de réfraction compris entre 1,66 et 1,72, notamment entre 1,68 et 1,70.

Ainsi, de manière très surprenante, intercaler entre couche fonctionnelle et substrat une couche additionnelle dont on sélectionne l'épaisseur optique permet d'obtenir une couleur en réflexion dans les bleus, même et surtout si la couche fonctionnelle est relativement épaisse, c'est-à-dire d'au moins 300 nm afin de présenter une émissivité suffisamment basse et/ou une conductivité électrique suffisamment élevée.

Cette couche intermédiaire adapte donc la coloration en réflexion du substrat en fonction des besoins esthétiques actuels sans que cela s'opère au détriment des performances de la couche fonctionnelle, grâce à son épaisseur optique, fonction de l'épaisseur géométrique souhaitée de la couche fonctionnelle.

Deux natures de couche intermédiaire sont plus particulièrement adaptées. Celle-ci peut notamment être à base de silicium, d'oxygène et de carbone (Si, O, C) et/ou à base de silicium, d'oxygène et d'azote (Si, O, N), et obtenue de préférence par une technique de pyrolyse de précurseurs siliciés, notamment par voie gazeuse CVD (Chemical Vapor Deposition), comme enseigné dans la demande de brevet FR-A-2 677 639, ou par une technique de plasma-CVD comme enseigné dans la demande de brevet EP-A-413 617.

Mais cette couche intermédiaire peut également être constituée d'un mélange d'oxydes métalliques dont la proportion relative permet d'ajuster l'indice de réfraction souhaité. Lesdits oxydes sont choisis notamment dans le groupe suivant : oxyde d'aluminium, oxyde de titane, oxyde d'étain, oxyde de zinc, oxyde d'indium, comme mentionné dans la demande de brevet français FR-A-2 670 199. Est alors de préférence utilisée la technique de pyrolyse de poudre de précurseurs organométalliques. On peut également et plus spécifiquement utiliser une couche intermédiaire à base d'oxydes d'aluminium et de titane ou d'étain, obtenue de préférence par pyrolyse par voie liquide de précurseurs organo-métalliques comme proposé dans la demande de brevet européen EP-A-465 309.

La couche fonctionnelle est quant à elle avantageusement à base d'oxyde(s) métallique(s) dopé(s), appartenant au groupe comprenant l'oxyde d'indium dopé à l'étain (ITO), l'oxyde de zinc dopé à l'indium ZnO:In, au fluor ZnO:F, à l'aluminium ZnO:Al ou à l'étain ZnO:Sn, ainsi que l'oxyde d'étain dopé au fluor $SnO_2$:F, ce dernier oxyde constituant le mode de réalisation préféré de l'invention.

Cette couche peut également être fabriquée à l'aide de technique de pyrolyse, notamment de composés pulvérulents. Ainsi, les couches de $SnO_2$:F et d'ITO peuvent être avantageusement obtenues par pyrolyse de poudres.

On peut fabriquer les couches de $SnO_2$:F à partir d'oxyde de dibutylétain (DBTO) en poudre et d'acide fluorhydrique anhydre gazeux, comme il est décrit dans le brevet FR-2 380 997, à partir de difluorure de dibutylétain (DBTF), éventuellement en mélange avec du DBTO comme décrit dans le document EP-A-178 956 ou EP-A-039 256.

En ce qui concerne les couches d'ITO, on peut les obtenir par exemple à partir de formiate d'indium et d'un composé de l'étain comme le DBTO décrit dans le document EP-A-192 009.

On peut aussi obtenir les couches de $SnO_2$:F par pyrolyse en phase gazeuse, notamment à partir d'un mélange de composés d'étain comme $(CH_3)_2$ $SnCl_2$, $(C_4H_9)_2$ $SnCl_2$, $Sn(C_2H_5)_4$ et de composés organofluorés tels que $CCl_2F_2$, $CHClF_2$ et $CH_3CHF_2$ comme décrit dans la demande de brevet EP-A-027 403 ou bien encore à partir de monobutyl trichloroétain et d'un composé tel que le chlorodifluorométhane mentionné dans la demande de brevet EP-A-121 459.

Les couches de $SnO_2$:F peuvent aussi être obtenues en phase liquide à partir d'acétylacétonate d'étain ou de diméthylétain-2-propionate dans des solvants organiques appropriés comme décrits notamment dans le brevet FR-2 211 411.

Les couches d'oxyde de zinc dopé à l'indium ou à l'aluminium peuvent être obtenues par pyrolyse en phase vapeur, à partir de diéthylzinc ou d'acétate de zinc et de triéthylindium, chlorure d'indium ou triéthylaluminium, chlorure d'aluminium, comme décrit dans la demande de brevet EP-A-335 769.

Ce procédé d'obtention des couches minces préféré selon l'invention consiste ainsi à déposer au moins une des deux couches par une technique de pyrolyse de précurseurs organo-métalliques ou siliciés, et de préférence à opérer les deux dépôts par une technique de pyrolyse.

Dans une installation de fabrication float, on peut procéder au premier dépôt de la couche intermédiaire par CVD dans l'enceinte float elle-même, et au second dépôt de la couche fonctionnelle par pyrolyse de poudre sur le ruban de verre entre enceinte float et étenderie.

D'autres détails et caractéristiques avantageuses de l'invention ressortent de la description ci-après d'exemples de réalisation non limitatifs, à l'aide de la figure suivante :

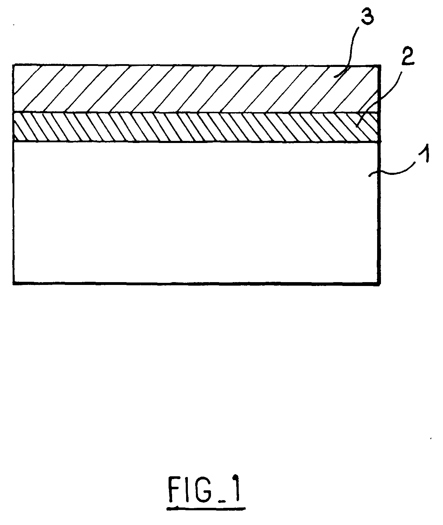

-    Fig 1 : une coupe transversale d'un subtrat revêtu selon l'invention.

Pour mettre en pratique l'invention, et selon les exemples suivants, il a donc fallu ajuster l'épaisseur optique de la couche intermédiaire 2 en fonction de l'épaisseur de la couche fonctionnelle 3 afin d'obtenir la longueur d'onde dominante et par là même la couleur résiduelle voulues.

Ces exemples, comme indiqué en figure 1, se rapportent à un substrat 1 en verre clair silico-sodo-calcique de 4 mm d'épaisseur, surmonté d'une couche intermédiaire 2 à base de silicium, d'oxygène et de carbone et obtenue par CVD selon l'enseignement de la demande de brevet français précitée FR-A-2 677 639, puis d'une couche fonctionnelle 3 en $SnO_2$:F obtenue de manière connue par pyrolyse de poudre à partir de D.B.T. F. comme décrit dans les brevets pré-cités.

On précise que la représentation de la figure 1 est très schématique et ne respecte pas les proportions relatives d'épaisseurs des matériaux 1, 2, 3 pour plus de clarté.

Toutes les mesures spectro-photométriques ont été effectuées en référence à l'illuminant $D_{65}$.

Les abréviations utilisées dans le tableau 1 ci-après qui résume les caractéristiques en réflexion lumineuse des exemples ont la signification suivante : $R_L$ (%) réflexion lumineuse en pourcentage : pe la pureté d'excitation en pourcentage mesurée à incidence normale, et $\lambda$ dom la longueur d'onde dominante en nanomètres dans le diagramme de chromaticité (x, y) ; c la saturation avec c = $\sqrt{a^2 + b^2}$ dans le système de colorimétrie (L*, a*, b*) et CR la couleur résiduelle en réflexion "côté couches".

Les épaisseurs des couches 2 et 3 sont exprimées en nanomètres.

EXEMPLE 1

La couche fonctionnelle 3 est en $SnO_2$:F d'une épaisseur géométrique de 340 nm et d'un indice de réfraction sensiblement égal à 1,9. La couche intermédiaire 2 à base de Si, O, C a une épaisseur géométrique d'environ 95 à 100 nm et un indice de réfraction sensiblement égal à 1,68, ce qui correspond à une épaisseur optique d'environ 168 nm.

Le substrat ainsi revêtu présente une émissivité de 0,17 et une apparence en réflexion côté "couches" ayant une couleur résiduelle bleue très lavée de blanc.

EXEMPLE 2

La couche fonctionnelle 3 a les même caractéristiques que précédemment. La couche intermédiaire 2 en Si, O, C a une épaisseur géométrique de 110 nm et un indice de réfraction d'environ 1,68, ce qui correspond à une épaisseur optique d'environ 185 nm.

Le substrat revêtu a une émissivité égale à celui de l'exemple 1. Son apparence en réflexion côté couches est un peu moins neutre que dans l'exemple 1, mais avec une différence d'intensité de coloration à peine perceptible, la couleur résiduelle restant dans la gamme des bleus.

EXEMPLE 3

La couche intermédiaire 2 présente les mêmes caractéristiques que celles de l'exemple 1. Par contre, la couche fonctionnelle de $SnO_2$:F a une épaisseur de 400 nm. La couleur résiduelle est toujours dans les bleus.

Tableau 1

| ex. | $R_L$ | Pe | λ dom | C | CR |
|---|---|---|---|---|---|
| 1 | 12 | 4,7 | 487 | 2,8 | bleu |
| 2 | 12 | 6,3 | 491 | 4,6 | bleu |
| 3 | 12 | 5 | 480 | - | bleu |

Il ressort de ces exemples que l'invention autorise l'obtention d'une couleur bleue en réflexion, dans le cas où la couche fonctionnelle est épaisse, et ceci avec de nombreux avantages additionnels.

En effet, tout d'abord, les valeurs de saturation et de pureté sont faibles, ce qui implique que la teinte bleue est assez "lavée de blanc", c'est-à-dire douce, pastel et donc agréable à l'oeil. En effet, les saturations de couleur résiduelle restent, selon l'invention, à une valeur inférieure à 7 et même inférieure à 5.

En outre, il a été constaté que visuellement le substrat côté couches garde sa coloration bleue en réflexion quel que soit le degré d'incidence de vision. Ainsi, une façade d'immeuble, par exemple, entièrement équipée de vitrages comportant ce type de substrat revêtu, garde, pour un spectateur extérieur, un aspect en coloration bleu parfaitement homogène et continu sur toute sa surface.

**Revendications**

1. Vitrage comprenant un substrat en verre (1) muni d'au moins une couche (3) mince transparente fonctionnelle, conductrice et/ou basse émissive, et d'une couche mince intermédiaire (2) disposée entre ledit substrat (1) et ladite couche fonctionnelle (3), caractérisé en ce que la couche fonctionnelle (3) a un indice de réfraction proche de 1,9 et une épaisseur comprise entre 300 et 420 nm et en ce que l'épaisseur optique de cette couche intermédiaire (2) est choisie comprise entre 168 et 185 nm, de manière à obtenir une couleur résiduelle en réflexion côté couches du substrat qui appartienne à la gamme des bleus définie par une gamme de longueurs d'onde comprise entre 462 et 490 nanomètres approximativement, ladite couleur résiduelle ayant une valeur de saturation c dans le système de colorimétrie (L*, a*, b*) inférieure ou égale à 7.

2. Vitrage selon la revendication 1, caractérisé en ce que l'indice de réfraction de la couche intermédiaire (2) est compris entre 1,66 et 1,72, de préférence entre 1,68 et 1,70.

3. Vitrage selon l'une des revendications précédentes, caractérisé en ce que la couche fonctionnelle (3) comporte au moins un oxyde métallique dopé appartenant au groupe comprenant l'oxyde d'indium dopé à l'étain ITO, l'oxyde de zinc dopé à l'indium ZnO:In, au fluor, ZnO:F, à l'aluminium ZnO:Al ou à l'étain ZnO:Sn, l'oxyde d'étain dopé au fluor $SnO_2F$.

4. Vitrage selon l'une des revendications précédentes, caractérisé en ce que la couche fonctionnelle (3) est une couche pyrolysée à partir de composés pulvérulents.

5. Vitrage selon l'une des revendications précédentes, caractérisé en ce que la couche intermédiaire (2) est à base de silicium, d'oxygène, et de carbone (Si, O, C) et/ou de silicium, d'oxygène, et d'azote (Si, O, N).

6. Vitrage selon l'une des revendications 1 à 4, caractérisé en ce que la couche intermédiaire (2) est à base de mélanges d'oxydes métalliques, comprenant notamment de l'oxyde d'aluminium et au moins un oxyde de zinc, d'indium, d'étain ou de titane.

7. Vitrage selon l'une des revendications 1 à 5, <u>caractérisé en ce que</u> la couche intermédiaire (2) à base de (Si, O, C) a une épaisseur physique d'environ 95 à 110 nm et un indice de réfraction d'environ 1,68 et en ce que la couche fonctionnelle (3), en $SnO_2$:F, a une épaisseur physique d'environ 340 nm à 400 nm, la couleur résiduelle en réflexion côté couches étant bleue.

8. Vitrage selon la revendication 7, <u>caractérisé en ce qu'il</u> présente en réflexion côté couches une couleur résiduelle dont la saturation c dans le système de colorimétrie (L*, a*, b*) est inférieure à 5, dans la gamme des bleus.

9. Procédé d'obtention du vitrage selon l'une des revendications précédentes, <u>caractérisé en ce qu'au</u> moins la couche fonctionnelle (3) et/ou la couche intermédiaire (2) sont déposées par une technique de pyrolyse de précurseurs organo-métalliques ou siliciés.

10. Procédé d'obtention selon la revendication <u>9, caractérisé en ce que</u> la couche intermédiaire (2), lorsqu'elle est à base de (Si, O, C) ou (Si, O, N) est déposée par une technique de pyrolyse par voie gazeuse (CVD).

11. Procédé d'obtention selon la revendication 9 ou 10, <u>caractérisé en ce que</u> la couche fonctionnelle (3), lorsqu'elle est à base de $SnO_2$:F, est déposée par une technique de pyrolyse de poudre, notamment de précurseurs organo-métalliques tels que le difluorure de dibutylétain (DBTF).

## Patentansprüche

1. Verglasung, welche ein Glassubstrat (1) umfaßt, das mit mindestens einer transparenten, funktionellen dünnen Schicht (3), die leitfähig ist und/oder ein niedriges Emissionsvermögen aufweist, und einer zwischen dem Substrat (1) und der funktionellen Schicht (3) angeordneten dünnen Zwischenschicht (2) versehen ist, **dadurch gekennzeichnet, daß** die funktionelle Schicht (3) einen Brechungsindex von etwa 1,9 und eine Dicke von 300 bis 420 nm besitzt **und daß** die optische Dicke dieser Zwischenschicht (2) von 168 bis 185 nm derart ausgewählt ist, daß unter reflektiertem Licht auf der Seite der Schichten des Substrats eine Restfärbung erhalten wird, die zum blauen Bereich gehört, der durch einen Wellenlängenbereich von etwa 462 bis 490 Nanometer definiert ist, wobei diese Restfärbung in der Farbmetrik (L*, a*, b*) einen Sättigungswert c von kleiner oder gleich 7 hat.

2. Verglasung nach Anspruch 1, **dadurch gekennzeichnet, daß** der Brechungsindex der Zwischenschicht (2) 1,66 bis 1,72 und vorzugsweise 1,68 bis 1,70 beträgt.

3. Verglasung nach einem der vorhergehenden Ansprüche, **dadurch gekennzeichnet, daß** die funktionelle Schicht (3) mindestens ein dotiertes Metalloxid enthält, das zu der Gruppe gehört, die mit Zinn dotiertes Indiumoxid, ITO, mit Indium, ZnO:In, Fluor, ZnO:F, Aluminium, ZnO:Al, oder Zinn, ZnO:Sn, dotiertes Zinkoxid und mit Fluor dotiertes Zinnoxid, $SnO_2$:F, umfaßt.

4. Verglasung nach einem der vorhergehenden Ansprüche, **dadurch gekennzeichnet, daß** die funktionelle Schicht (3) durch Pyrolyse pulverförmiger Verbindungen erhalten ist.

5. Verglasung nach einem der vorhergehenden Ansprüche, **dadurch gekennzeichnet, daß** die Zwischenschicht (2) Silicium, Sauerstoff und Kohlenstoff (Si, O, C) und/oder Silicium, Sauerstoff und Stickstoff (Si, O, N) zur Grundlage hat.

6. Verglasung nach einem der Ansprüche 1 bis 4, **dadurch gekennzeichnet, daß** die Zwischenschicht (2) Metallmischoxide zur Grundlage hat, die insbesondere Aluminiumoxid und mindestens ein Oxid des Zinks, Indiums, Zinns oder Titans enthalten.

7. Verglasung nach einem der Ansprüche 1 bis 5, **dadurch gekennzeichnet, daß** die geometrische Dicke der Zwischenschicht (2) auf der Grundlage von (Si, O, C) etwa 95 bis 110 nm und ihr Brechungsindex etwa 1,68 beträgt **und daß** die geometrische Dicke der funktionellen Schicht (3) aus $SnO_2$:F etwa 340 bis 400 nm beträgt, wobei die Restfärbung unter reflektiertem Licht auf der Seite der Schichten blau aussieht.

8. Verglasung nach Anspruch 7, **dadurch gekennzeichnet, daß** sie unter reflektiertem Licht auf der Seite der Schichten eine Restfärbung aufweist, deren Sättigungswert c in der Farbmetrik (L*, a*, b*) im blauen Bereich kleiner als 5 ist.

9. Verfahren zur Herstellung der Verglasung nach einem der vorhergehenden Ansprüche, **dadurch gekennzeichnet, daß** wenigstens die funktionelle Schicht (3) und/oder die Zwischenschicht (2) durch ein Verfahren zur Pyrolyse metallorganischer oder siliciumhaltiger Vorläufer aufgebracht ist/sind.

10. Herstellungsverfahren nach Anspruch 9, **dadurch gekennzeichnet, daß** die Zwischenschicht (2), wenn sie (Si, O, C) oder (Si, O, N) zur Grundlage hat, durch ein Gasphasenabscheidungsverfahren (CVD) aufgebracht ist.

11. Herstellungsverfahren nach Anspruch 9 oder 10, **dadurch gekennzeichnet,** daß die funktionelle Schicht (3), wenn sie $SnO_2$:F zur Grundlage hat, durch ein Verfahren der Pulverpyrolyse, insbesondere metallorganischer Vorläufer wie Dibutylzinndifluorid (DBTF), aufgebracht ist.

## Claims

1. Glazing pane comprising a glass substrate (1) provided with at least one conducting and/or low emissivity, transparent functional thin film (3), and with an intermediate thin film (2) disposed between said substrate (1) and said functional film (3), characterized in that the functional film (3) has a refractive index close to 1.9 and a thickness lying between 300 and 420 nm and in that the optical thickness of this intermediate film (2) is chosen to lie between 168 and 185 nm, so as to obtain a residual colour in reflection at the film side of the substrate which belongs to the range of the blues defined by a wavelength range lying between 462 and 490 nanometres approximately, said residual colour having a saturation value c in the colorimetry system (L*, a*, b*) less than or equal to 7.

2. Glazing pane according to claim 1, characterized in that the refractive index of the intermediate film (2) lies between 1.66 and 1.72, preferably between 1.68 and 1.70.

3. Glazing pane according to one of the preceding claims, characterized in that the functional film (3) comprises at least one doped metallic oxide belonging to the group comprising indium oxide doped with tin ITO, zinc oxide doped with indium ZnO:In, with fluorine ZnO:F, with aluminium ZnO:Al or with tin ZnO:Sn, tin oxide doped with fluorine $SnO_2$F.

4. Glazing pane according to one of the preceding claims, characterized in that the functional film (3) is a film pyrolyzed from pulverulent compounds.

5. Glazing pane according to one of the preceding claims, characterized in that the intermediate film (2) is based upon silicon, oxygen and carbon (Si, O, C) and/or upon silicon, oxygen and nitrogen (Si, O, N).

6. Glazing pane according to one of claims 1 to 4, characterized in that the intermediate film (2) is based upon mixtures of metallic oxides comprising, notably, aluminium oxide and at least one oxide of zinc, indium, tin or titanium.

7. Glazing pane according to one of claims 1 to 5, characterized in that the intermediate film (2), based upon (Si, O, C), has a physical thickness of approximately 95 to 110 nm and a refractive index of approximately 1.68 and in that the functional film (3), of $SnO_2$:F, has a physical thickness of approximately 340 nm to 400 nm, the residual colour in reflection at the film side being blue.

8. Glazing pane according to claim 7, characterized in that it has, in reflection at the film side, a residual colour, the saturation c of which in the colorimetry system (L*, a*, b*) is less than 5, in the range of the blues.

9. Method of production of the glazing pane according to one of the preceding claims, characterized in that at least the functional film (3) and/or the intermediate film (2) are deposited by a technique of pyrolysis of organo-metallic or silicon-combined precursors.

10. Production method according to claim 9, characterized in that the intermediate film (2), when it is based upon (Si, O, C) or (Si, O, N), is deposited by a pyrolysis technique by gaseous process (CVD).

11. Production method according to claim 9 or 10, characterized in that the functional film (3), when it is based upon $SnO_2$:F, is deposited by a powder pyrolysis technique, notably of organo-metallic precursors such as dibutyl tin difluoride (DBTF).

FIG_1